# EUROPEAN PATENT SPECIFICATION

(11) **EP 4 002 443 B1**
(45) Date of publication and mention of the grant of the patent: **26.06.2024**
(21) Application number: 20857829.4
(22) Date of filing: 18.08.2020
(51) Int. Cl.: H01L 23/373, C09K 5/14, H01L 23/42, G01R 31/12

(54) **HEAT-RADIATING SHEET AND METHOD OF PRODUCING HEAT-RADIATING SHEET**
WÄRMEABSTRAHLENDE FOLIE UND VERFAHREN ZUR HERSTELLUNG EINER WÄRMEABSTRAHLENDEN FOLIE
FEUILLE À RAYONNEMENT THERMIQUE ET SON PROCÉDÉ DE FABRICATION

(30) Priority: 23.08.2019 JP 2019152674
(43) Date of publication of application: 25.05.2022
(73) Proprietor: Denka Company Limited, Tokyo 103-8338 (JP)
(72) Inventor: WADA, Kosuke, Tokyo 103-8338 (JP); KANEKO, Masahide, Tokyo 103-8338 (JP); NONOGAKI, Ryozo, Tokyo 103-8338 (JP)
(74) Representative: Gulde & Partner
(86) International application number: PCT/JP2020/031119
(87) International publication number: WO 2021/039500

(56) References cited:
- JP-A- 2012 039 061
- JP-A- 2017 105 930
- JP-A- 2017 105 930
- JP-A- 2018 104 253
- JP-A- 2018 104 253
- JP-A- 2018 156 758
- JP-A- 2018 156 758
- JP-A- 2019 010 773
- JP-A- 2019 010 773

## Description

### Technical Field

The present invention relates to a heat-diffusion sheet and a method of producing a heat-diffusion sheet.

### Background Art

In heat-generating electronic components, such as power devices, transistors, thyristors, and CPUs, how to efficiently radiate heat generated at the time of use is an important issue. As a countermeasure against such heat radiation, in general, the heat radiation has hitherto been performed by conducting the heat generated from the heat-generating electronic component into a heat-diffusion component, such as a heat sink. In order to thermally conduct the heat generated from the heat-generating electronic component with efficiency into the heat-diffusion component, it is desired to fill an air gap at a contact interface between the heat-generating electronic component and the heat-diffusion component with a heat-generating material. Heat-diffusion sheets have hitherto been used as such a heat-diffusion material because of easy handling (see, for example, JP 2012-39060 A).

JP 2018 156758 A discloses an insulation sheet contains a fibrous material, an inorganic particle, and a binder resin, the insulation sheet satisfying the following (i)-(iii): (i) a thickness of 20 pm or more and 400 pm or less; (ii) a thermal diffusion rate in thickness direction of 1×10-7 m/s or more; (iii) a breakdown voltage of 25 kV/mm or more. JP 2019 010773 A relates to a composite thermoconductive sheet which has an insulation resin sheet, a metal foil arranged on a single side or double side of the insulation resin sheet, and a substrate sheet arranged in an opposite side of the metal foil arranged on the single surface of the insulation resin sheet to a side facing the insulation resin sheet, or an opposite side of one or both of metal foil arranged on the double surface of the insulation resin sheet facing to a side of the insulation resin sheet, and having a thermoconductive filler with anisotropy, in which at least a part of the thermoconductive filler with anisotropy orients a longer axis direction to a thickness direction of the substrate sheet. JP 2018 104253 A describes an aggregate formed by bonding hexagonal boron nitride primary particles obtained by firing a mixture containing a compound containing boron, a compound containing nitrogen, and borate of lithium or sodium, where a graphitization index is 1.8 to 2.2, a ratio of a length of a long side of the particles of less than 1 pm is 25-50%, a ratio of the length of 1 pm or more and 5 pm or less is 50-75%, and a ratio of the length exceeding 5 pm is 5% or less, an average particle diameter is 10-200 pm, a content of the metal impurities is 10 ppm or less, and a particle collapse strength is 1-4 MPa. JP 2017 105930 A relates to an addition curable silicon rubber composition contains (A) organopolysiloxane represented by the following formula (1), R¹ₐ SiO_{(4-a)/2}, where R is monovalent hydrocarbon group and a is a positive number of 1.5 to 2.8, and containing an alkenyl group binding to at least 2 silicon atoms in a molecule, (B) organohydrogen polysiloxane having at least 2 hydrogen atoms binding silicon atom (SiH functional group) in a molecule, (C) reinforcement silica and (D) an addition reaction catalyst with content of the (E) organopolysiloxane containing one or more Si-OH functional group with polymerization degree of 10 or less in a molecule of 0.005 to 0.3 mass% based on the whole composition. JP 2012 039061 A describes a heat-conductive sheet comprising plate-like boron nitride particles which has a coefficient of thermoconductivity of ≥4 W/m K in the plane direction SD of the heat-conductive sheet, and volume resistivity R of≥1×10Ω cm. The heat-conductive sheet, when covering electronic elements, can protect the electronic elements, effectively conduct the heat of the electronic elements and prevent short circuit among the electronic elements.

### Summary of Invention

### Technical Problem

There is a case where the heat-diffusion sheet is required to have excellent insulation in addition to excellent thermal conductivity. In such a case, when insulation failure is generated in the heat-diffusion sheet, there is a case where an excessive electric current flows into the heat-generating electronic component, and a damage against the heat-generating electronic component becomes large. For this reason, it is needed that the generation of insulation failure of the heat-diffusion sheet does not occur as far as possible.

Then, an object of the present invention is to provide a heat-diffusion sheet capable of suppressing the generation of insulation failure and a method of producing the heat-diffusion sheet.

### Solution to Problem

In order to achieve the aforementioned object, the present inventors made extensive and intensive investigations. As a result, it has been found that even if a heat-diffusion sheet per se is free from a defect, the insulation failure of the heat-diffusion sheet is generated owing to a burr produced in the heat-diffusion component or insertion of a foreign matter on the occasion of arranging the heat-diffusion sheet between a heat-generating electronic component and a heat-diffusion component. But, it is difficult to completely prevent a burr produced in the heat-diffusion component at the time of molding or processing, and it is also difficult to completely prevent the insertion of a foreign matter on the occasion of arranging the heat-diffusion sheet between the heat-generating electronic component and the heat-diffusion component. Accordingly, it is desired to make the heat-diffusion sheet free from generation of insulation failure even if a burr is produced in the heat-diffusion component, or a foreign matter is inserted on the occasion of arranging the heat-diffusion sheet between the heat-generating electronic component and the heat-diffusion component.

In order to achieve the aforementioned object, the present inventors further made extensive and intensive investigations. As a result, in the case of carrying out a dielectric breakdown test by using a needle electrode as an upper electrode, using an aluminum plate as a lower electrode, and penetrating the needle electrode into the heat-diffusion sheet, a heat-diffusion sheet in which a distance between a distal end of the needle electrode and the aluminum plate at the time of dielectric breakdown of the heat-diffusion sheet falls within a predetermined range, or a heat-diffusion sheet in which the needle electrode short-circuits the aluminum plate without dielectric breakdown of the heat-diffusion sheet, is able to suppress generation of insulation failure of the heat-diffusion sheet owing to a burr produced in the heat-diffusion component or insertion of a foreign matter on the occasion of arranging the heat-diffusion sheet between a heat-generating electronic component and a heat-diffusion component.

The present invention is based on the aforementioned findings, and a gist thereof is as follows.

The present invention relates to a heat-diffusion sheet having a thickness of more than 10 pm, wherein a distance between a distal end of a needle electrode and the aluminum plate at the time of dielectric breakdown of the heat-diffusion sheet is larger than 0 pm and 80 pm or less, or the needle electrode short-circuits the aluminum plate without dielectric breakdown of the heat-diffusion sheet, when a dielectric breakdown test is performed and the breakdown test comprises a needle electrode having a cone having a height of 3 mm and a bottom surface diameter of 0.75 mm at a distal end section thereof, to which a 2.0-kV alternating current voltage having a frequency of 60 Hz has been impressed, is not only penetrated stepwise every 10 pm into the heat-diffusion sheet placed directly on an aluminum plate in the thickness direction of the heat-diffusion sheet from the surface at the opposite side to the surface in contact with the aluminum plate of the heat-diffusion sheet but also retained for 60 seconds before the penetration and at each of the steps.

According to one embodiment of the heat-diffusion sheet of the present invention, the distance between the distal end of the needle electrode and the aluminum plate at the time of dielectric breakdown of the heat-diffusion sheet is 50 pm or less when the dielectric breakdown test is performed.

According to a further embodiment, the heat-diffusion sheet of the present invention, contains a resin binder and an inorganic filler.

In a preferred embodiment of the heat-diffusion sheet of the present invention, the resin binder is a silicone resin.

In a preferred embodiment of the heat-diffusion sheet of the present invention, the inorganic filler is a coagulated particle of hexagonal boron nitride.

According to one embodiment of the heat-diffusion sheet of the present invention, contains a glass cloth.

According to another embodiment of the heat-diffusion sheet of the present invention, contains a base material resin layer including a resin having a glass transition point of 200°C or higher.

The present invention also relates to a method of producing a heat-diffusion sheet, including a composition fabricating step of mixing a liquid resin composition, an inorganic filler, and a solvent to fabricate a composition for heat-diffusion sheet; a sheet molding step of molding the composition for heat-diffusion sheet in a sheet form to fabricate a composition sheet for heat-diffusion sheet; a pre-heating step of pre-heating the composition sheet for heat-diffusion sheet at a pre-heating temperature of lower than a curing starting temperature while pressurizing the composition sheet for heat-diffusion sheet; and a curing step of heating the composition sheet for heat-diffusion sheet at a temperature of the curing starting temperature or higher while pressurizing the pre-heated composition sheet for heat-diffusion sheet, wherein the inorganic filler is a massively coagulated particle, and the composition sheet for heat-diffusion sheet is not cured in the pre-heating step.

According to one embodiment of the method of producing a heat-diffusion sheet of the present invention, wherein the liquid resin composition is a liquid silicone resin composition; the inorganic filler is a coagulated particle of hexagonal boron nitride; in the pre-heating step, the pressure at the time of pressurizing the composition sheet for heat-diffusion sheet is 50 to 200 kgf/cm², and the pre-heating temperature is 50 to 80°C; and in the curing step, the pressure at the time of pressurizing the composition sheet for heat-diffusion sheet is 50 to 200 kgf/cm², and the temperature of the curing starting temperature or higher is 130 to 200°C.

In a preferred embodiment of the method of producing a heat-diffusion sheet of the present invention, wherein in the pre-heating step, the heating time of pre-heating the composition sheet for heat-diffusion sheet at the pre-heating temperature is 5 to 10 minutes; and in the curing step, the heating time of heating the composition sheet for heat-diffusion sheet at a temperature of the curing starting temperature or higher is 10 to 60 minutes.

In a preferred embodiment of the method of producing a heat-diffusion sheet of the present invention, further including a low-molecular weight siloxane removal step of heating the composition sheet for heat-diffusion sheet heated at a temperature of the curing starting temperature or higher at a heating temperature of 130 to 200°C for 2 to 30 hours.

### Advantageous Effects of Invention

In accordance with the present invention, it is possible to provide a heat-diffusion sheet capable of suppressing generation of insulation failure owing to a burr in the heat-diffusion component or a foreign matter incorporated between a heat-generating electronic component and a heat-diffusion sheet or between a heat-diffusion component and the heat-diffusion sheet; and a method of producing the heat-diffusion sheet.

### Brief Description of Drawings

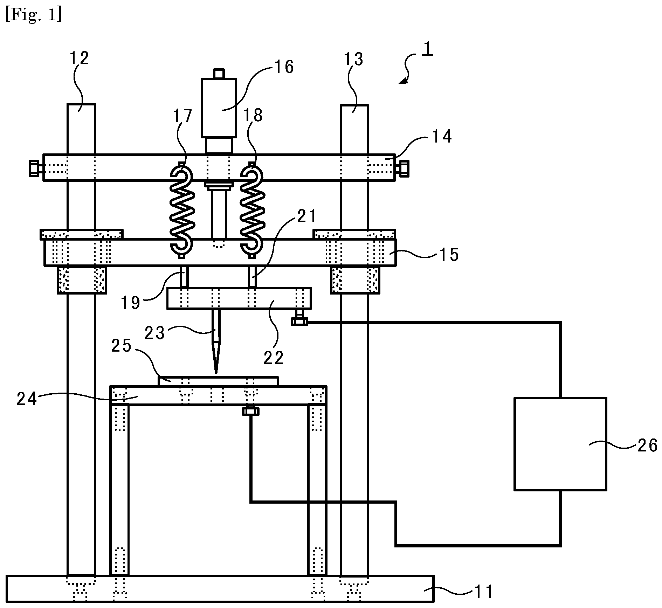

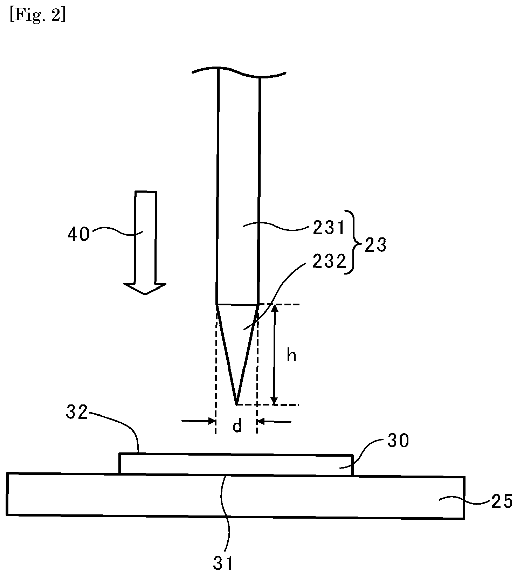

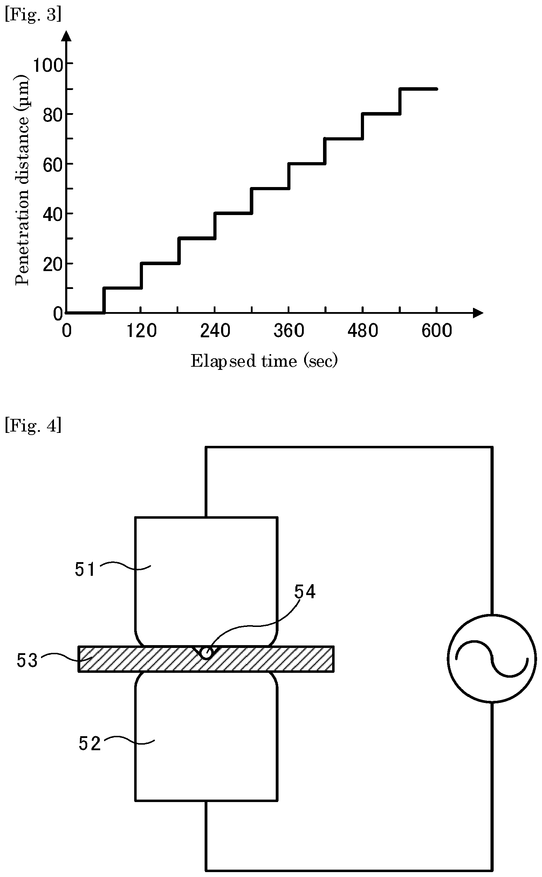

"Fig. 1" is a schematic view showing an example of a withstanding voltage tester used for a dielectric breakdown test.
"Fig. 2" is a schematic view for explaining a heat-diffusion sheet placed in a withstanding voltage tester.
"Fig. 3" is a graph showing a relation between a penetration distance of a needle electrode into a heat-diffusion sheet and an elapsed time in a dielectric breakdown test.
"Fig. 4" is a schematic view for explaining a test method of a foreign matter resistance evaluation test.

### Description of Embodiments

### [Heat-Diffusion Sheet]

### The heat-diffusion sheet of the present invention is hereunder described. (Distance between distal end of needle electrode and aluminum plate at the time of dielectric breakdown of heat-diffusion sheet)

A thickness of the heat-diffusion sheet of the present invention is more than 10 um. Furthermore, as for the heat-diffusion sheet of the present invention, when a needle electrode having a cone having a height of 3 mm and a bottom surface diameter of 0.75 mm at a distal end section thereof, to which a 2.0-kV alternating current voltage having a frequency of 60 Hz has been impressed, is not only penetrated stepwise every 10 pm into the heat-diffusion sheet placed directly on an aluminum plate in the thickness direction of the heat-diffusion sheet from the surface at the opposite side to the surface in contact with the aluminum plate of the heat-diffusion sheet but also retained for 60 seconds before the penetration and at each of the steps, a distance between the distal end of the needle electrode and the aluminum plate at the time of dielectric breakdown of the heat-diffusion sheet is larger than 0 pm and 80 pm or less, or the needle electrode short-circuits the aluminum plate without dielectric breakdown of the heat-diffusion sheet. In the aforementioned dielectric breakdown test, when the distance between the distal end of the needle electrode and the aluminum plate at the time of dielectric breakdown of the heat-diffusion sheet is larger than 80 µm, there is a case where the electric insulation between a heat-generating electronic component and a heat-diffusion component cannot be secured owing to a burr in the heat-diffusion component or a foreign matter incorporated between the heat-generating electronic component and the heat-diffusion sheet or between the heat-diffusion component and the heat-diffusion sheet. In addition, when the distance between the distal end of the needle electrode and the aluminum plate is 0 pm, the needle electrode short-circuits the aluminum plate, so that the heat-diffusion sheet does not undergo dielectric breakdown. For such viewpoint, in the aforementioned dielectric breakdown test, the distance between the distal end of the needle electrode and the aluminum plate at the time of dielectric breakdown of the heat-diffusion sheet is preferably 50 pm or less, more preferably 30 pm or less, and still more preferably 20 pm or less.

Among heat-diffusion sheets which are unable to suppress generation of insulation failure owing to a burr in the heat-diffusion component or a foreign matter incorporated between the heat-generating electronic component and the heat-diffusion sheet or between the heat-diffusion component and the heat-diffusion sheet, there is one causing the dielectric breakdown before penetrating the needle electrode. Then, when the thickness of this heat-diffusion sheet is 80 pm or less, in the aforementioned dielectric breakdown test, the distance between the distal end of the needle electrode and the aluminum plate at the time of dielectric breakdown of the heat-diffusion sheet becomes 80 pm or less. For this reason, the heat-diffusion sheet of the present invention is preferably a heat-diffusion sheet in which in the aforementioned dielectric breakdown test, the dielectric breakdown does not occur in the first penetration with 10 pm of the needle electrode into the heat-diffusion sheet, whereas the dielectric breakdown occurs in the second or subsequent penetrations with 10 µm of the needle electrode into the heat-diffusion sheet. Then, it is preferred that the distance between the distal end of the needle electrode and the aluminum plate at the time of dielectric breakdown of the heat-diffusion sheet in the second or subsequent penetrations with 10 pm of the needle electrode into the heat-diffusion sheet is larger than 0 pm and 80 pm or less, or the needle electrode short-circuits the aluminum plate without dielectric breakdown of the heat-diffusion sheet.

The distance between the distal end of the needle electrode and the aluminum plate at the time of dielectric breakdown of the heat-diffusion sheet in the second or subsequent penetrations with 10 pm of the needle electrode into the heat-diffusion sheet is preferably larger than 0 pm and 50 pm or less, more preferably larger than 0 pm and 30 pm or less, and still more preferably larger than 0 pm and 20 pm or less.

The reason why the thickness of the heat-diffusion sheet of the present invention is more than 10 pm resides in the matter of making the needle electrode possible to penetrate with at least 10 pm into the heat-diffusion sheet without causing short circuit of the needle electrode with the aluminum plate. An upper limit of the thickness of the heat-diffusion sheet is not particularly limited but may be appropriately set according to applications.

The aforementioned dielectric breakdown test can be, for example, carried out using a withstanding voltage tester shown in Fig. 1. A withstanding voltage tester 1 is provided with a base plate 11; two struts 12 and 13 vertically provided on the base plate 11; a fixing plate 14 fixed to the two struts 12 and 13 and installed between the two struts 12 and 13; a lifting plate 15 provided downward the fixing plate 14 and installed in a vertically movable manner between the two struts 12 and 13; a micrometer head 16 in which a stem is fixed to the fixing plate 14, and a distal end of a spindle is fixed to the lifting plate 15; springs 17 and 18 provided such that the distal end of the spindle of the micrometer head 16 does not come off from the lifting plate 15, in each of which one end is fixed to the fixing plate 14, and the other end is fixed to the lifting plate 15; two hanging rods 19 and 21 having insulation, which are provided suspended from the lifting plate 15; an aluminum plate 22 provided downward the lifting plate 15 via the hanging rods 19 and 21; an aluminum -made needle electrode 23 provided suspended from the aluminum plate 22; a table 24 having insulation, which is placed on the base plate 11; an aluminum plate 25 placed on the table 24; and a withstanding voltage measuring instrument 26 not only impressing a 2.0-kV alternating current voltage having a frequency of 60 Hz between the aluminum plate 22 provided downward the lifting plate 15 and the aluminum plate 25 placed on the table 24 but also measuring the dielectric breakdown of the heat-diffusion sheet. For the withstanding voltage measuring instrument 26, for example, a withstanding voltage tester (Model No: TOS 5101), manufactured by Kikusui Electronics Corporation can be used.

When a thimble of the micrometer head 16 is rotated, the spindle of the micrometer head 16 moves, whereby the lifting plate 15 to which the distal end of the spindle has been fixed moves in the vertical direction. Following this, the aluminum plate 22 also moves in the vertical direction, and the needle electrode 23 provided suspended from the aluminum plate 22 also moves in the vertical direction. In consequence, by rotating the thimble of the micrometer head 16, the needle electrode 23 can be moved in the vertical direction. In addition, a moving distance of the needle electrode 23 in the vertical direction can be read from a scale of the micrometer head 16. Furthermore, since there is conductivity between the aluminum plate 22 and the needle electrode 23, when an alternating current voltage is impressed between the two aluminum plates 22 and 25, the same alternating current voltage is impressed, too between the needle electrode 23 and the aluminum 25.

As shown in Fig. 2, a heat-diffusion sheet 30 is placed directly on the aluminum plate 25. Then, the needle electrode 23 moves in the direction of an arrow 40 and penetrates in the thickness direction of the heat-diffusion sheet 30 from a surface 32 at the opposite side of a surface 31 of the heat-diffusion sheet 30 in contact with the aluminum plate 25. The needle electrode 23 has a main body section 231 and a distal end section 232. Then, the distal end section 232 is a cone having a height (h) of 3 mm and a bottom surface diameter (d) of 0.75 mm.

Fig. 3 is a graph showing a relation between a penetration distance of the needle electrode into the heat-diffusion sheet and an elapsed time in the dielectric breakdown test. As shown in Fig. 3, before penetrating the needle electrode into the heat-diffusion sheet, an alternating current voltage is impressed between the needle electrode and the aluminum electrode, followed by retaining for 60 seconds. Then, the needle electrode is penetrated with 10 pm into the heat-diffusion sheet and retained for 60 seconds. In the case where no dielectric breakdown of the heat-diffusion sheet occurs, the needle electrode is further penetrated with 10 pm into the heat-diffusion sheet and retained for 60 seconds. In the dielectric breakdown test, a process of penetrating the needle electrode with 10 pm into the heat-diffusion sheet and retaining for 60 seconds is performed until the dielectric breakdown of the heat-diffusion sheet occurs, or the needle electrode short-circuits the aluminum plate.

In the aforementioned dielectric breakdown test, it may be considered that the reason why the distance between the distal end of the needle electrode and the aluminum plate at the time of dielectric breakdown of the heat-diffusion sheet of the present invention is larger than 0 pm and 80 pm or less, or the needle electrode short-circuits the aluminum plate without dielectric breakdown of the heat-diffusion sheet of the present invention resides in the matter that by heating and pressurizing a composition sheet for heat-diffusion sheet as mentioned later while gradually raising the temperature from a low temperature, voids in the heat-diffusion sheet have been reduced. More specifically, the following reason may be considered. However, it should be construed that this reason does not limit the present invention.

The heat-diffusion sheet of the present invention can be, for example, fabricated by molding a composition for heat-diffusion sheet containing a resin, an inorganic filler, and a glass cloth to fabricate a composition sheet for heat-diffusion sheet and then heating and pressurizing the composition sheet for heat-diffusion sheet at a predetermined temperature to undergo curing. Furthermore, as for the heat-diffusion sheet of the present invention, before heating and pressurizing the composition sheet for heat-diffusion sheet at the aforementioned predetermined temperature to undergo curing, the composition sheet for heat-diffusion sheet is heated and pressurized at a pre-heating temperature lower than a curing starting temperature of the composition sheet for heat-diffusion sheet. At the stage of heating at the pre-heating temperature, the composition sheet for heat-diffusion sheet is not cured, and therefore, it may be considered that air bubbles in the resin can be sufficiently removed through heating and pressurization. In addition, it may be considered that a part of gaps of fibers of the glass cloth is filled with the inorganic filler through heating and pressurization, or the aforementioned gaps are crushed by the inorganic filler. Then, it may be considered that owing to these matters, the insulation of the heat-diffusion sheet is improved.

In addition, in the case of using massive coagulated particles as the inorganic filler, it may be considered that the insulation of the heat-diffusion sheet can be further improved for the following reason. In this case, the heat-diffusion sheet of the present invention can be fabricated by molding a composition for heat-diffusion sheet containing a resin, massive coagulated particles, and a glass cloth to fabricate a composition sheet for heat-diffusion sheet and then heating and pressurizing the composition sheet for heat-diffusion sheet at a predetermined temperature to undergo curing. Furthermore, as for the heat-diffusion sheet of the present invention, before heating and pressurizing the composition sheet for heat-diffusion sheet at the aforementioned temperature to undergo curing, the composition sheet for heat-diffusion sheet is heated and pressurized at a pre-heating temperature lower than a curing starting temperature of the composition sheet for heat-diffusion sheet. At this stage, the composition sheet for heat-diffusion sheet is not cured, and therefore, air bubbles in the resin can be sufficiently removed through heating and pressurization. In addition, the resin can also be sufficiently filled in voids in the massive coagulated particles. Furthermore, the resin can also be sufficiently filled in voids in the glass cloth. In this way, since the air bubbles or voids as a cause of the dielectric breakdown are sufficiently removed, in the aforementioned dielectric breakdown test, it may be considered that the distance between the distal end of the needle electrode and the aluminum plate at the time of dielectric breakdown of the heat-diffusion sheet of the present invention is larger than 0 pm and 80 pm or less, or the needle electrode short-circuits the aluminum plate without dielectric breakdown of the heat-diffusion sheet of the present invention.

In addition, at the stage of heating and pressurizing the composition sheet for heat-diffusion sheet at the pre-heating temperature, the composition sheet for heat-diffusion sheet is not cured, and therefore, the coagulated particles are loosened through pressurization. When the heat-diffusion sheet undergoes dielectric breakdown, the electric current passes through the inside of the resin. In consequence, when the coagulated particles are loosened through pressurization, in the dielectric breakdown test, at the time of occurrence of dielectric breakdown, the electric current passes and flows through the resin having voids of a massive primary particle aggregate filled therein, and therefore, the electric current flows between the needle electrode and the aluminum plate after passing through a complicated route.

In the light of the above, the heat-diffusion sheet of the present invention becomes hard to undergo dielectric breakdown, and in the aforementioned dielectric breakdown test, it may be considered that the distance between the distal end of the needle electrode and the aluminum plate at the time of dielectric breakdown of the heat-diffusion sheet of the present invention is larger than 0 pm and 80 pm or less, or the needle electrode short-circuits the aluminum plate without dielectric breakdown of the heat-diffusion sheet of the present invention.

### (Thickness of Heat-Diffusion Sheet)

The thickness of the heat-diffusion sheet of the present invention is more than 10 µm. When the thickness of the heat-diffusion sheet of the present invention is 10 pm or less, the needle electrode cannot be penetrated with 10 pm into the heat-diffusion sheet without causing short-circuit of the needle electrode with the aluminum plate. In addition, the thickness of the heat-diffusion sheet of the present invention is preferably larger than 20 um. When the thickness of the heat-diffusion sheet of the present invention is larger than 20 pm, the heat-diffusion sheet is able to more likely follow unevennesses of the mounting surface of the heat-generating electronic component. From such viewpoint, the thickness of the heat-diffusion sheet of the present invention is more preferably 25 pm or more, still more preferably 50 pm or more, yet still more preferably 100 pm or more, and especially preferably 150 pm or more. In addition, from the viewpoint that thermal resistance of the heat-diffusion sheet can be reduced, the thickness of the heat-diffusion sheet of the present invention is preferably 1,000 pm or less, and more preferably 650 pm or less.

### (Components of Heat-Diffusion Sheet)

It is preferred that the heat-diffusion sheet of the present invention contains a resin binder and an inorganic filler. According to this, in the case of performing the aforementioned dielectric breakdown test, it becomes easy to fabricate the heat-diffusion sheet in which the distance between the distal end of the needle electrode and the aluminum plate at the time of dielectric breakdown of the heat-diffusion sheet is larger than 0 pm and 80 µm or less, or the needle electrode short-circuits the aluminum plate without dielectric breakdown of the heat-diffusion sheet.

### <Resin Binder>

The resin binder which is used for the heat-diffusion sheet of the present invention is not particularly limited so long as it is a resin binder usually used for a heat-diffusion sheet. Examples of the resin binder which is used for the heat-diffusion sheet of the present invention include epoxy resins, silicone resins, acrylic resins, phenol resins, melamine resins, urea resins, unsaturated polyesters, fluorine resins, polyamides (for example, polyimide, polyamide-imide, and polyether imide), polyesters (for example, polybutylene terephthalate and polyethylene terephthalate), polyphenylene ethers, polyurethanes, polyphenylene sulfides, wholly aromatic polyesters, polysulfones, liquid crystal polymers, polyether sulfones, polycarbonates, maleimide-modified resins, ABS resins, AAS (acrylonitrile-acrylic rubber/styrene) resins, and AES (acrylonitrile/ethylene/propylene/diene rubber-styrene) resins. These can be used either alone or in combination of two or more thereof. From the viewpoint of facilitating handling of the heat-diffusion sheet and the viewpoint of more enhancing adhesion of the heat-diffusion sheet owing to flexibility of the heat-diffusion sheet, the resin binder is preferably a rubber or an elastomer. Of these, silicone resins are preferred from the viewpoint of heat resistance, weather resistance, electric insulation, and chemical stability.

From the viewpoint that ionic impurities as a cause of metal corrosion are not contained and that by-products are not formed after the reaction, the silicone resin which is used for the heat-diffusion sheet of the present invention is preferably an addition reaction type silicone resin. The addition reaction type silicone resin is one resulting from curing through a hydrosilylation reaction between an alkenyl group and a hydrogen atom bound to a silicon atom using a platinum compound as a catalyst. Examples of the addition reaction type silicone resin include a trade name "LR3303-20A/B", manufactured by Wacker Asahikasei Silicone Co., Ltd.

### <Inorganic Filler>

The inorganic filler (in this specification, occasionally expressed as "filler") which is used for the heat-diffusion sheet of the present invention is not particularly limited so long as it is an inorganic filler usually used for a heat-diffusion sheet and the inorganic filler is a massively coagulated particle. Examples of the inorganic filler which is used for the heat-diffusion sheet of the present invention include zinc oxide, alumina, boron nitride, aluminum nitride, silicon carbide, and silicon nitride. These can be used either alone or in combination of two or more thereof. Of these, a massively coagulated inorganic filler is more preferred. In addition, among the inorganic fillers, boron nitride is more preferred from the viewpoint of thermal conductivity and chemical stability. Since the boron nitride has anisotropy in the thermal conductivity, a massive boron nitride particle in which the anisotropy of thermal conductivity is suppressed is still more preferred. The massive boron nitride particle is a particle resulting from massively coagulating flaky particles of hexagonal boron nitride.

### (a) Average Particle Diameter of Inorganic Filler

An average particle diameter of the inorganic filler is preferably 5 to 90 um. When the average particle diameter of the inorganic filler is 5 pm or more, the content of the inorganic filler can be made high. On the other hand, when the average particle diameter of the inorganic filler is 90 pm or less, the heat-diffusion sheet can be made thin. From such viewpoint, the average particle diameter of the inorganic filler is more preferably 10 to 70 pm, still more preferably 15 to 50 pm, and especially preferably 15 to 45 um. The average particle diameter of the inorganic filler can be, for example, measured using a laser diffraction scattering particle size analyzer (LS-13 320), manufactured by Beckman-Coulter, Inc. As the average particle diameter of the inorganic filler, one measured without applying a homogenizer thereto before the measurement treatment can be adopted. In consequence, in the case where the inorganic filler is a coagulated particle, the average particle diameter of the inorganic filler is the average particle diameter of the coagulated particles. The obtained average particle diameter is, for example, an average particle diameter in terms of a volume statistics value.

### (b) Content of Inorganic Filler

The content of the inorganic filler relative to 100% by volume of the total of the resin binder and the inorganic filler is preferably 30 to 85% by volume. In the case where the content of the inorganic filler is 30% by volume or more, the thermal conductivity of the heat-diffusion sheet is improved, and a sufficient heat-diffusion performance is readily obtained. In addition, in the case where the content of the inorganic filler is 85% by volume or less, the matter that the voids are liable to be formed at the time of molding the heat-diffusion sheet can be suppressed, and the insulation and mechanical strength of the heat-diffusion sheet can be enhanced. From such viewpoint, the content of the inorganic filler relative to 100% by volume of the total of the resin binder and the inorganic filler is more preferably 40 to 80% by volume, and still more preferably 45 to 70% by volume.

### <Reinforcing Layer>

The heat-diffusion sheet of the present invention may be provided with a reinforcing layer. The reinforcing layer takes a role to further improve the mechanical strength of the heat-diffusion sheet, and moreover, when the heat-diffusion sheet is compressed in the thickness direction, there is also brought an effect for suppressing elongation to the planar direction of the heat-diffusion sheet to secure the insulation. Examples of the reinforcing layer include a glass cloth; a resin film made of polyester, polyamide, polyimide, polycarbonate, acrylic resin, etc.; a cloth fiber mesh cloth made of cotton, hemp, aramid fiber, cellulose fiber, nylon fiber, polyolefin fiber, etc.; a nonwoven fabric made of aramid fiber, cellulose fiber, nylon fiber, polyolefin fiber, etc.; a metal fiber mesh cloth made of stainless steel, copper, aluminum, etc.; and a metal foil made of copper, nickel, aluminum, etc. These can be used either alone or in combination of two or more thereof. Of these, a glass cloth is preferred from the viewpoint of thermal conductivity and insulation.

In the case of using a glass cloth as the reinforcing layer, a generally marketed glass cloth having openings can be used. A thickness of the glass cloth is preferably 10 pm to 150 pm. In the case where the thickness of the glass cloth is 10 pm or more, the glass cloth can be suppressed from breakage at the time of handling. On the other hand, in the case where the thickness of the glass cloth is 150 pm or less, a lowering of the thermal conductivity of the heat-diffusion sheet owing to the glass cloth can be suppressed. From such viewpoint, the thickness of the glass cloth is more preferably 20 to 90 pm, and still more preferably 30 to 60 pm. Among marketed glass clothes, there are ones having a fiber diameter of 4 to 9 um, and these can be used for the heat-diffusion sheet. In addition, a tensile strength of the glass cloth is, for example, 100 to 1,000 N/25 mm. In addition, a length of one side of the opening of the glass cloth is preferably 0.1 to 1.0 mm from the viewpoint of balancing between the thermal conductivity and the strength. Examples of the glass cloth which can be used for the heat-diffusion sheet include a trade name "H25 F104", manufactured by Unitika Ltd. The reinforcing layer may be arranged near the center in the thickness direction of the heat-diffusion sheet. The wording "near the center" is a range of "center ± 1/4" thickness in the thickness direction.

The heat-diffusion sheet may contain other component than the resin binder, the inorganic filler, and the reinforcing layer. Examples of the other component include additives and impurities. The content of the other component in 100% by volume of the volume of the heat-diffusion sheet is, for example, 5% by volume or less, preferably 3% by volume or less, and more preferably 1% by volume or less.

Examples of the additives include a reinforcing agent, an extending agent, a heat resistance-improving agent, a flame retarder, an adhesive aid, a conducting agent, a surface treatment agent, and a pigment.

### <Base Material Resin Layer>

It is preferred that the heat-diffusion sheet of the present invention contains a base material resin layer. The base material resin layer takes a role to further improve the heat resistance and insulation of the heat-diffusion sheet. In this case, the heat-diffusion sheet of the present invention contains a resin composition layer containing the aforementioned resin binder and inorganic filler and a base material resin layer adjacent to this resin composition layer. The resin composition layer may be provided with the aforementioned reinforcing layer. The resin composition layer is preferably composed mainly of the resin binder and the inorganic filler, and the content of the other component may be 10% by volume or less, may be 5% by volume or less, may be 3% by volume or less, or may be 1% by volume or less.

The base material resin layer preferably contains a resin having a glass transition point of 200°C or higher. When the glass transition point is 200°C or higher, sufficient heat resistance is obtained, and the insulation or thermal conductivity of the laminate can be maintained favorable. The base material resin layer may be a layer formed of a coating film or may be formed of a film.

Examples of the resin constituting the base material resin layer include a polyimide, a polyamide-imide, a polyamide (in particular, an aromatic polyamide), a polyether sulfone, a polyether imide, polyethylene naphthalate, polytetrafluoroethylene (PTFE), and a tetrafluoroethylene/perfluoroalkyl vinyl ether copolymer (PFA). Above all, a polyimide is preferred. In addition, these resins can be used either alone or in combination of several kinds thereof.

Although the content of the resin in the base material resin layer is not particularly limited, a lower limit thereof is preferably 78% by volume or more, more preferably 80% by volume or more, and still more preferably 82% by volume or more. An upper limit thereof is preferably 92% by volume or less, more preferably 90% by volume or less, and still more preferably 88% by volume or less.

It is preferred that the base material resin layer contains an inorganic filler. When the base material resin layer contains an inorganic filler, the insulation, thermal conductivity, peel strength, and so on can be improved. In particular, it may be assumed that the rise of the peel strength resides in the matter that unevennesses are formed at an interface between the base material resin layer and the resin composition layer owing to the inorganic filler, whereby an anchor effect is produced. As the inorganic filler, the same materials as those in the aforementioned inorganic filler can be used.

Although the content of the inorganic filler in the base material resin layer is not particularly limited, a lower limit thereof is preferably 8% by volume or more, more preferably 10% by volume or more, and still more preferably 12% by volume or more. An upper limit thereof is preferably 22% by volume or less, more preferably 20% by volume or less, and still more preferably 18% by volume or less.

In the base material resin layer, the aforementioned additives may be contained in small amounts, and the impurities may be contained in small amounts. In the base material resin layer, the total content of the aforementioned resin and inorganic filler is preferably 90% by volume or more, more preferably 95% by volume or more, and still more preferably 97% by volume or more.

From the viewpoint of insulation, thermal conductivity, and processability, the thickness of the base material resin layer is preferably the following range. A lower limit thereof is preferably 0.010 mm or more. By setting the thickness of the base material resin layer to 0.010 mm or more, not only the insulation can be further improved, but also the processability can be improved, too. The thickness of the base material resin layer is more preferably 0.012 mm or more, and still more preferably 0.015 mm or more. An upper limit thereof is preferably 0.100 mm or less, more preferably 0.070 mm or less, and still more preferably 0.050 mm or less.

The film serving as the base material resin layer can be fabricated in conformity with a known film fabricating method. In addition, products which are on sale in the market may be acquired and used.

### <Form of Heat-Diffusion Sheet>

The form of the heat-diffusion sheet of the present invention is not particularly limited. The heat-diffusion sheet of the present invention may be any of a sheet product and a roll product.

### [Production Method of Heat-Diffusion Sheet]

The production method of the heat-diffusion sheet of the present invention includes a composition fabricating step of mixing a liquid resin composition, an inorganic filler, and a solvent to fabricate a composition for heat-diffusion sheet; a sheet molding step of molding the composition for heat-diffusion sheet in a sheet form to fabricate a composition sheet for heat-diffusion sheet; a pre-heating step of pre-heating the composition sheet for heat-diffusion sheet at a pre-heating temperature lower than a curing starting temperature while pressurizing the composition sheet for heat-diffusion sheet; and a curing step of heating the composition sheet for heat-diffusion sheet at a temperature of the curing starting temperature or higher while pressurizing the pre-heated composition sheet for heat-diffusion sheet, wherein the composition sheet for heat-diffusion sheet is not cured in the pre-heating step. According to this, the heat-diffusion sheet of the present invention can be produced. Each of the steps is hereunder described in detail.

### (Composition Fabricating Step)

In the composition fabricating step, a liquid resin composition, an inorganic filler, and a solvent are mixed to fabricate a composition for heat-diffusion sheet. The liquid resin composition is a resin composition that is in a liquid state at room temperature (25°C). The liquid resin composition is a liquid resin composition which when cured, becomes the resin binder of the heat-diffusion sheet of the present invention. From the viewpoint of obtaining a silicone resin that is the preferred resin binder, the liquid resin composition is preferably a liquid silicone rubber. As the inorganic filler, the same materials as those described for the filler which is used for the heat-diffusion sheet of the present invention can be used. The inorganic filler is preferably a massively coagulated particle, and more preferably a massive boron nitride particle. The solvent is, for example, used as a viscosity modifier. The solvent is not particularly limited so long as it is able to dissolve the liquid resin composition therein. Examples of the solvent include hydrocarbon-based solvents, such as hexane, toluene, and heptane; and ketone-based solvents, such as acetone and methyl ethyl ketone. The solvent is preferably a hydrocarbon-based solvent, and more preferably toluene.

### (Sheet Molding Step)

In the sheet molding step, the composition for heat-diffusion sheet is molded in a sheet form to fabricate a composition sheet for heat-diffusion sheet. For example, the composition for heat-diffusion sheet can be molded in a sheet form by applying the composition for heat-diffusion sheet on a film having releasability and drying at 60 to 80°C for 4 to 7 minutes. The application method is not particularly limited, and a known application method capable of performing uniform application, such as a doctor blade method, a comma coater method, a screen printing method, and a roll coater method, can be adopted. But, from the viewpoint that the thickness of the applied composition for heat-diffusion sheet can be controlled with high accuracy, a doctor blade method and a comma coater method are preferred. In the case where the heat-diffusion sheet is provided with the reinforcing layer, it is preferred that after placing the reinforcing layer on the film having releasability, the composition for heat-diffusion sheet is applied and dried. In this case, the composition for heat-diffusion sheet may be applied on both surfaces of the reinforcing layer such that the reinforcing layer is arranged in the center in the thickness direction of the heat-diffusion sheet, followed by drying.

In the case of the heat-diffusion sheet provided with the base material resin layer, the resin composition is applied on a base material sheet serving as the base material resin layer. As the application method on the base material sheet, a conventionally known method, for example, a coater method, a doctor blade method, an extrusion molding method, an injection molding method, and a press molding method, can be adopted. Even in the case of the heat-diffusion sheet provided with the base material resin layer, the composition for heat-diffusion sheet may be applied on both surfaces of the base material resin layer such that the base material resin layer is arranged in the center in the thickness direction of the heat-diffusion sheet, followed by drying.

### (Pre-heating Step)

In the pre-heating step, the composition sheet for heat-diffusion sheet is pre-heated at a pre-heating temperature lower than a curing starting temperature while pressurizing the composition sheet for heat-diffusion sheet. Since the composition sheet for heat-diffusion sheet is not cured at the pre-heating temperature, according to this step, the air bubbles or voids as a cause of the dielectric breakdown of the heat-diffusion sheet are sufficiently removed, and the insulation failure of the heat-diffusion sheet which is generated owing to a burr in the heat-diffusion component or a foreign matter incorporated between the heat-generating electronic component and the heat-diffusion sheet or between the heat-diffusion component and the heat-diffusion sheet can be suppressed. The curing starting temperature means a temperature at which an exothermic peak to be caused due to curing the heat-diffusion sheet rises in the differential scanning calorimetry (DSC) of the heat-diffusion sheet. In consequence, the composition sheet for heat-diffusion sheet does not start to cure at a temperature lower than the curing starting temperature. A temperature of exothermic peak on the occasion of mixing silicones LR3303-20A and LR3303-20B, both of which are manufactured by Wacker Asahikasei Silicone Co., Ltd., in a proportion of 1/1 as used in the section of Examples and measuring by means of the differential scanning calorimetry (DSC) was 90°C. In addition, in order to make the curing starting temperature high, a curing retarder or the like may be appropriately added.

In the case where the inorganic filler is a coagulated particle, according to this step, the coagulated particles are loosened to become a massive primary particle aggregate in which primary particles are massively gathered owing to a weak interparticle interaction force. The electric current passes and flows through the resin having voids of the massive primary particle aggregate filled therein in the heat-diffusion sheet. As a result, the electric current flows after passing through a complicated route. According to this, the insulation failure is hardly caused in the heat-diffusion sheet, and the insulation failure of the heat-diffusion sheet which is generated owing to a burr in the heat-diffusion component or a foreign matter incorporated between the heat-generating electronic component and the heat-diffusion sheet or between the heat-diffusion component and the heat-diffusion sheet can be suppressed.

A pressure at the time of pressurizing the composition sheet for heat-diffusion sheet in the pre-heating step is preferably 50 to 200 kgf/cm². By setting the pressure at the time of pressurizing the composition sheet for heat-diffusion sheet to 50 kgf/cm² or more, the air bubbles in the resin can be further sufficiently removed to increase the density of the heat-diffusion sheet, whereby the insulation of the heat-diffusion sheet can be improved. In addition, by setting the pressure at the time of pressurizing the composition sheet for heat-diffusion sheet to 200 kgf/cm² or less, not only the productivity of the heat-diffusion sheet can be improved, but also the production costs can be reduced.

In the case where the inorganic filler is a coagulated particle, since the coagulated particles can be loosened while keeping the shape of the coagulated particle, the insulation failure can be suppressed without lowering the thermal conductivity. From such viewpoint, the pressure at the time of pressurizing the composition sheet for heat-diffusion sheet is more preferably 70 to 150 kgf/cm².

A pre-heating temperature is preferably 50 to 80°C. By setting the pre-heating temperature to 50°C or higher, occurrence of the matter that coagulation of the massively coagulated particles in the composition sheet for heat-diffusion sheet excessively collapse, and the particles are oriented, whereby the thermal conductivity of the heat-diffusion sheet is lowered can be suppressed. In addition, by setting the heating temperature to 80°C or lower, the air bubbles in the resin without curing the resin are sufficiently removed to increase the density of the heat-diffusion sheet, whereby the insulation of the heat-diffusion sheet can be improved. From such viewpoint, the pre-heating temperature is more preferably 55 to 75°C.

Aheating time of pre-heating the composition sheet for heat-diffusion sheet at the pre-heating temperature is preferably 5 to 10 minutes. By setting the heating time to 5 minutes or more, the air bubbles in the resin are sufficiently removed to increase the density of the heat-diffusion sheet, whereby the insulation of the heat-diffusion sheet can be improved. In addition, by setting the heating time to 10 minutes or less, not only the productivity of the heat-diffusion sheet can be improved, but also the production costs can be reduced. From such viewpoint, the heating time is more preferably 6 to 9 minutes.

### (Curing Step)

In the curing step, the composition sheet for heat-diffusion sheet is heated at a temperature of the curing starting temperature or higher while pressurizing the pre-heated composition sheet for heat-diffusion sheet. According to this, the composition sheet for heat-diffusion sheet is cured to become the heat-diffusion sheet.

A pressure at the time of pressurizing the composition sheet for heat-diffusion sheet in the curing step is preferably 100 to 200 kgf/cm². By setting the pressure at the time of pressurizing the composition sheet for heat-diffusion sheet to 100 kgf/cm² or more, the air bubbles in the resin are further removed to increase the density of the heat-diffusion sheet, whereby the insulation of the heat-diffusion sheet can be further improved. In addition, in the case where the heat-diffusion sheet has the reinforcing layer, bondability between the resin and the reinforcing layer can be improved. In addition, by setting the pressure at the time of pressurizing the composition sheet for heat-diffusion sheet to 200 kgf/cm² or less, not only the productivity of the heat-diffusion sheet can be improved, but also the production costs can be reduced. From such viewpoint, the pressure at the time of pressurizing the composition sheet for heat-diffusion sheet is more preferably 130 to 180 kgf/cm². In addition, as mentioned above, in the present invention, for the purpose of reducing the amount of voids in the heat-diffusion sheet by gradually performing heating and pressurization, a pressurizing force in the curing step is larger than a pressurizing force in the pre-heating.

Although a temperature of heating the pre-heated composition sheet for heat-diffusion sheet in the curing step is not particularly limited so long as it is a temperature of the curing starting temperature or higher, it is preferably 130 to 200°C. By setting the heating temperature of the composition sheet for heat-diffusion sheet to 130°C or higher, the composition sheet for heat-diffusion sheet can be further sufficiently cured. In addition, by setting the heating temperature of the composition sheet for heat-diffusion sheet to 200°C or lower, not only the productivity of the heat-diffusion sheet can be improved, but also the production costs can be reduced. From such viewpoint, the heating temperature of the composition sheet for heat-diffusion sheet is more preferably 140 to 180°C.

A heating time of heating the composition sheet for heat-diffusion sheet in the curing step is preferably 10 to 60 minutes. By setting the heating time to 10 minutes or more, the composition sheet for heat-diffusion sheet can be further sufficiently cured. In addition, by setting the heating time to 60 minutes or less, not only the productivity of the heat-diffusion sheet can be improved, but also the production costs can be reduced.

### (Low-Molecular Weight Siloxane Removal Step)

It is preferred that the production method of the heat-diffusion sheet of the present invention further includes a low-molecular weight siloxane removal step of heating the composition sheet for heat-diffusion sheet heated at a temperature of the curing starting temperature or higher at a heating temperature of 130 to 200°C for 2 to 30 hours. According to this, the low-molecular weight siloxane in the resin can be removed. When the concentration of the low-molecular weight siloxane in the resin is high, there is a case where a siloxane gas is emitted, an insulating coating film made of silicone oxide is produced on an electrical contact owing to energy, such as sliding and a spark of the electrical contact, thereby causing a contact fault.

By setting the heating temperature to 130°C or higher, the low-molecular weight siloxane in the resin can be sufficiently removed. By setting the heating temperature to 200°C or lower, flexibility of the heat-diffusion sheet can be secured. In addition, not only the productivity of the heat-diffusion sheet can be improved, but also the production costs can be reduced. From such viewpoint, the heating temperature is more preferably 140 to 190°C.

By setting the heating time to 2 hours or more, the low-molecular weight siloxane in the resin can be sufficiently removed. By setting the heating time to 30 hours or less, not only the productivity of the heat-diffusion sheet can be improved, but also the production costs can be reduced. From such viewpoint, the heating time is more preferably 3 to 10 hours.

### Examples

The present invention is hereunder described in detail by reference to Examples and Comparative Examples. It should be construed that the present invention is not limited to the following Examples.

The heat-diffusion sheets of the Examples and Comparative Examples were subjected to the following evaluations.

### (Thickness of Heat-Diffusion Sheet)

The thickness of the heat-diffusion sheet was measured with a micrometer with respect to ten optional places, and an average value thereof was expressed as the thickness of the heat-diffusion sheet of each of the Examples and Comparative Examples.

### (Dielectric Breakdown Test)

The dielectric breakdown test was performed using the withstanding voltage tester shown in Fig. 1, and the distance between the distal end of the needle electrode and the aluminum plate at the time of dielectric breakdown of the heat-diffusion sheet was measured. A withstanding voltage tester (Model No: TOS 5101), manufactured by Kikusui Electronics Corporation was used as the withstanding voltage tester. Using this withstanding voltage tester, a 2.0-kV alternating current voltage having a frequency of 60 Hz was impressed between the needle electrode and the aluminum plate. In addition, as mentioned above, the dielectric breakdown test was performed using the needle electrode having a cone having a height of 3 mm and a bottom surface diameter of 0.75 mm at a distal end section thereof.

After placing the heat-diffusion sheet on the aluminum plate on the table, the thimble of the micrometer head was rotated, and the needle electrode was descended until the distal end of the needle electrode came into contact with the heat-diffusion sheet without being penetrated thereinto. Then, after impressing an alternating current voltage between the needle electrode and the aluminum plate, this state was retained for 60 seconds. In the case where no dielectric breakdown of the heat-diffusion sheet occurred, the thimble of the micrometer head was rotated to descend the needle electrode with 10 um, thereby penetrating the needle electrode with 10 pm into the heat-diffusion sheet. Then, this state was retained for 60 seconds.

In the case where no dielectric breakdown of the heat-diffusion sheet occurred, the thimble of the micrometer head was rotated to further descend the needle electrode with 10 um, thereby further penetrating the needle electrode with 10 pm into the heat-diffusion sheet. In the case where the needle electrode came into contact with the aluminum plate, and the needle electrode did not short-circuit the aluminum plate, this state was retained for 60 seconds. In the case where no dielectric breakdown of the heat-diffusion sheet occurred, the thimble of the micrometer head was rotated to further descend the needle electrode with 10 um, thereby further penetrating the needle electrode with 10 µm into the heat-diffusion sheet. Then, in the case where the needle electrode came into contact with the aluminum plate, and the needle electrode did not short-circuit the aluminum plate, this state was retained for 60 seconds. Such an operation of descending and retaining the needle electrode was performed until the dielectric breakdown of the heat-diffusion sheet occurred, or the needle electrode short-circuited the aluminum plate.

Then, by subtracting the penetration distance of the needle electrode into the heat-diffusion sheet at the time of occurrence of the dielectric breakdown of the heat-diffusion sheet from the thickness of the heat-diffusion sheet, the distance between the distal end of the needle electrode and the aluminum plate at the time of dielectric breakdown of the heat-diffusion sheet was calculated. With respect to five heat-diffusion sheets, the distance between the distal end of the needle electrode and the aluminum plate at the time of dielectric breakdown of the heat-diffusion sheet was calculated, and an average value thereof was expressed as the distance between the distal end of the needle electrode and the aluminum plate at the time of dielectric breakdown of the heat-diffusion sheet of each of the Examples and Comparative Examples.

### (Foreign Matter Resistance Evaluation Test)

As shown in Fig. 4, a heat-diffusion sheet 53 and a foreign matter 54 (diameter: 100 um, aluminum) were sandwiched by a movable electrode 51 having a diameter of 25 mm (fixed to a non-illustrated lifting plate, which is energizable with the lifting plate) and a fixed electrode 52 having a diameter of 25 mm, and the dielectric breakdown test was performed in conformity with JIS C2110. A fixed voltage was impressed for 20 seconds, the voltage was raised stepwise until the dielectric breakdown occurred, and the resistance of the heat-diffusion sheet 53 to the foreign matter 54 was evaluated according to the following criteria.
A: The dielectric breakdown voltage is 6 kV or more.
B: The dielectric breakdown voltage is 4 kV or more and less than 6 kV
C: The dielectric breakdown voltage is less than 4 kV.

The heat-diffusion sheets of the Examples and Comparative Examples were fabricated in the following manner.

### [Example 1]

### (Fabrication of Hexagonal Boron Nitride)

Boric acid, melamine, and calcium carbonate (all being a special grade reagent) were mixed in a proportion of 70/50/5 in terms of a mass ratio; the temperature was raised in a nitrogen gas atmosphere from room temperature to 1,400°C over 1 hour; after retaining at 1,400°C for 3 hours, the temperature was raised to 1,900°C over 4 hours; and after retaining at 1,900°C for 2 hours, cooling to room temperature was performed to produce hexagonal boron nitride. After crushing this, the resultant was pulverized and sieved to fabricate a massive boron nitride particle. An average particle diameter of the fabricated massive boron nitride particle was 20 pm.

### (Fabrication of Composition for Heat-Diffusion Sheet)

To 22 g of a silicone resin (Model No.: LR3303-20A, manufactured by Wacker Asahikasei Silicone Co., Ltd.) and 22 g of a silicone resin (Model No.: LR3303-20B, manufactured by Wacker Asahikasei Silicone Co., Ltd.), 137 g of the fabricated massive boron nitride particle was added; then, toluene was added as a viscosity modifier such that the solid component concentration was 60 wt%; and the contents were mixed with a stirrer (trade name: Three-One Motor, manufactured by HEIDON Inc.) using a turbine type stirring blade for 15 hours, to fabricate a composition for heat-diffusion sheet.

### (Fabrication of Heat-Diffusion Sheet)

After arranging a glass cloth (trade name: H25 F 104, manufactured by Unitika Ltd.) as a reinforcing layer on a Teflon (registered trademark) sheet, the aforementioned composition for heat-diffusion sheet was applied in a thickness of 0.2 mm on the glass cloth by using a comma coater, followed by drying at 75°C for 5 minutes. Subsequently, the dried composition for heat-diffusion sheet was turned over such that the glass cloth was located on the upper side; and the composition for heat-diffusion sheet was applied in a thickness of 0.2 mm on the glass cloth by using a comma coater, followed by drying at 75°C for 5 minutes, to fabricate a sheet of the composition for heat-diffusion sheet in which the composition for heat-diffusion sheet was applied on the both surfaces of the glass cloth. Thereafter, using a flat plate pressing machine (manufactured by Yanase Seisakusho Co., Ltd.), pressing was performed for 8 minutes under conditions at a pre-heating temperature of 70°C and a pressure of 120 kgf/cm². Thereafter, the temperature was raised to 150°C at a temperature rise rate of 10°C/min while pressing at a pressure of 150 kgf/cm². Then, pressing was performed for 45 minutes under conditions at a heating temperature (temperature of the curing starting temperature or higher) of 150°C and a pressure of 150 kgf/cm², to fabricate a heat-diffusion sheet having a thickness of 0.30 mm. Subsequently, the resultant was heated for 4 hours at atmospheric pressure and at a temperature of 150°C to remove a low-molecular weight siloxane, thereby fabricating a heat-diffusion sheet of Example 1. The content of the inorganic filler was 60% by volume relative to 100% by volume of the total of the resin binder and the inorganic filler in the heat-diffusion sheet.

### [Example 2]

The thickness on the occasion of applying the composition for heat-diffusion sheet fabricated using the same raw materials as in Example 1 on the glass cloth by using a comma coater was changed from 0.2 mm to 0.15 mm. Subsequently, the dried composition for heat-diffusion sheet was turned over such that the glass cloth was located on the upper side, and applied in a thickness of 0.15 mm as changed from 0.2 mm on the glass cloth by using a comma coater. Other than that, the same method as in Example 1 was performed to fabricate a heat-diffusion sheet of Example 2 having a thickness of 0.20 mm.

### [Example 3]

In place of the glass cloth (trade name: H25 F104, manufactured by Unitika Ltd.), a polyimide film (trade name: Kapton 100H, manufactured by "DU PONT-TORAY CO., LTD., thickness: 0.026 mm) was arranged as a base material resin layer on a Teflon (registered trademark) sheet, and then, the aforementioned composition for heat-diffusion sheet was applied in a thickness of ∘∘ mm on the polyimide film by using a comma coater and dried at 75°C for 5 minutes, to fabricate a sheet of the composition for heat-diffusion sheet having the composition for heat-diffusion sheet applied on one surface of the polyimide film. Other than that, the same method as in Example 1 was performed to fabricate a heat-diffusion sheet of Example 3.

### [Comparative Example 1]

A heat-diffusion sheet of Comparative Example 1 was fabricated in the same manner as in Example 1, except that with respect to the sheet of the composition for heat-diffusion sheet having the composition for heat-diffusion sheet applied on the both surfaces of the glass cloth, the curing step was performed without performing the pre-heating step.

### [Example 4]

A heat-diffusion sheet of Example 4 was fabricated in the same method as in Example 1, except that to 17 g of a silicone resin (Model No.: LR3303-20A, manufactured by Wacker Asahikasei Silicone Co., Ltd.) and 17 g of a silicone resin (Model No.: LR3303-20B, manufactured by Wacker Asahikasei Silicone Co., Ltd.), 191 g of alumina (trade name: DAW-20, manufactured by Denka Company Limited) and 82 g of alumina (spherical) (trade name: DAW-03, manufactured by Denka Company Limited) were added; then, toluene was added as a viscosity modifier such that the solid component concentration was 80 wt%; and the contents were mixed with a stirrer (trade name: Three-One Motor, manufactured by HEIDON Inc.) using a turbine type stirring blade for 15 hours, to fabricate a composition for heat-diffusion sheet. The content of the inorganic filler was 70% by volume relative to 100% by volume of the total of the resin binder and the inorganic filler in the heat-diffusion sheet.

### [Example 5]

The thickness on the occasion of applying the composition for heat-diffusion sheet fabricated using the same raw materials as in Example 4 on the glass cloth by using a comma coater was changed from 0.2 mm to 0.15 mm. Subsequently, the dried composition for heat-diffusion sheet was turned over such that the glass cloth was located on the upper side, and applied in a thickness of 0.15 mm as changed from 0.2 mm on the glass cloth by using a comma coater. Other than that, the same method as in Example 4 was performed to fabricate a heat-diffusion sheet of Example 5.

### [Comparative Example 2]

A heat-diffusion sheet was fabricated in the same method as in Example 4, except that the pre-heating step was not performed.

The evaluation results of the heat-diffusion sheets of Examples 1 to 5 and Comparative Examples 1 and 2 are shown in Table 1.

**Table 1**

| | | Example 1 | Example 2 | Example 3 | Example 4 | Example 5 | Comparative Example 1 | Comparative Example 2 |
|---|---|---|---|---|---|---|---|---|
| Thickness | mm | 0.30 | 0.20 | 0.20 | 0.30 | 0.20 | 0.30 | 0.30 |
| Kind of inorganic filler | - | BN | BN | BN | Al₂O₃ | Al₂O₃ | BN | Al₂O₃ |
| Content of inorganic filler | % by volume | 60 | 60 | 60 | 70 | 70 | 60 | 70 |
| Reinforcing layer | - | Glass cloth | Glass cloth | - | Glass cloth | Glass cloth | Glass cloth | Glass cloth |
| Base material resin layer | - | - | - | Polyimide film | - | - | - | - |
| Distance between distal end of needle electrode and aluminum plate at the time of dielectric breakdown of heat-diffusion sheet | µm | 20 | 30 | 10 | 60 | 20 | 90 | 120 |
| Foreign matter resistance evaluation | - | A | A | A | B | B | C | C |

From the foregoing evaluation results, it was noted that in the aforementioned dielectric breakdown test, with respect to the heat-diffusion sheets in which the distance between the distal end of the needle electrode and the aluminum plate at the time of dielectric breakdown of the heat-diffusion sheet is larger than 0 pm and 80 pm or less, or the needle electrode short-circuits the aluminum plate without dielectric breakdown of the heat-diffusion sheet, the insulation failure hardly occurs even by being inserted with the foreign matter.

In addition, with respect to the heat-diffusion sheet of Example 1 in which the distance between the distal end of the needle electrode and the aluminum plate at the time of dielectric breakdown of the heat-diffusion sheet is 20 um, and the heat-diffusion sheet of Example 3 in which the distance between the distal end of the needle electrode and the aluminum plate at the time of dielectric breakdown of the heat-diffusion sheet is 10 pm, a short-time breakdown test was further performed at room temperature (23°C) in conformity with JIS C2110. As a result, as compared with the heat-diffusion sheet of Example 1, nevertheless the thickness became smaller, the heat-diffusion sheet of Example 3 was higher by 3 kV with respect to the dielectric breakdown voltage. According to this, it was noted that by providing the heat-diffusion sheet with the base material resin layer, the insulation failure more hardly occurs in the heat-diffusion sheet even by being inserted with the foreign matter.

### Reference Signs List

1: Withstanding voltage tester
11: Base plate
12, 13: Strut
14: Fixing plate
15: Lifting plate
16: Micrometer head
17, 18: Spring
19, 21: Hanging rod
22, 25: Aluminum plate
23: Needle electrode
24: Table
26: Withstanding voltage measuring instrument
30, 53: Heat-diffusion sheet
51: Movable electrode
52: Fixed electrode
54: Foreign matter

## Claims

1. A heat-diffusion sheet (30, 53) having a thickness of more than 10 pm,
wherein a distance between a distal end of a needle electrode (23) and an aluminum plate (22, 25) at the time of dielectric breakdown of the heat-diffusion sheet (30, 53) is larger than 0 pm and 80 pm or less, or the needle electrode (23) short-circuits the aluminum plate (22, 25) without dielectric breakdown of the heat-diffusion sheet (30, 53), when a dielectric breakdown test is performed and the breakdown test comprises a needle electrode (23) having a cone having a height of 3 mm and a bottom surface diameter of 0.75 mm at a distal end section thereof, to which a 2.0-kV alternating current voltage having a frequency of 60 Hz has been impressed, is not only penetrated stepwise every 10 pm into the heat-diffusion sheet (30, 53) placed directly on an aluminum plate (22, 25) in the thickness direction of the heat-diffusion sheet (30, 53) from the surface at the opposite side to the surface in contact with the aluminum plate (22, 25) of the heat-diffusion sheet (30, 53) but also retained for 60 seconds before the penetration and at each of the steps.

2. The heat-diffusion sheet (30, 53) according to claim 1, wherein the distance between the distal end of the needle electrode (23) and the aluminum plate (22, 25) at the time of dielectric breakdown of the heat-diffusion sheet (30, 53) is 50 pm or less, when the dielectric breakdown test is performed.

3. The heat-diffusion sheet (30, 53) according to claim 1 or 2, comprising a resin binder and an inorganic filler.

4. The heat-diffusion sheet (30, 53) according to claim 3, wherein the resin binder is a silicone resin.

5. The heat-diffusion sheet (30, 53) according to claim 3 or 4, wherein the inorganic filler is a coagulated particle of hexagonal boron nitride.

6. The heat-diffusion sheet (30, 53) according to any one of claims 3 to 5, comprising a glass cloth.

7. The heat-diffusion sheet (30, 53) according to any one of claims 3 to 6, comprising a base material resin layer including a resin having a glass transition point of 200°C or higher.

8. A method of producing a heat-diffusion sheet (30, 53), comprising
a composition fabricating step of mixing a liquid resin composition, an inorganic filler, and a solvent to fabricate a composition for heat-diffusion sheet (30, 53);
a sheet molding step of molding the composition for heat-diffusion sheet (30, 53) in a sheet form to fabricate a composition sheet for heat-diffusion sheet (30, 53);
a pre-heating step of pre-heating the composition sheet for heat-diffusion sheet (30, 53) at a pre-heating temperature lower than a curing starting temperature while pressurizing the composition sheet for heat-diffusion sheet (30, 53); and
a curing step of heating the composition sheet for heat-diffusion sheet (30, 53) at a temperature of the curing starting temperature or higher while pressurizing the pre-heated composition sheet for heat-diffusion sheet (30, 53),
wherein the inorganic filler is a massively coagulated particle, and the composition sheet for heat-diffusion sheet (30, 53) is not cured in the pre-heating step.

9. The method of producing a heat-diffusion sheet (30, 53) according to claim 8, wherein
the liquid resin composition is a liquid silicone resin composition;
the inorganic filler is a coagulated particle of hexagonal boron nitride;
in the pre-heating step, the pressure at the time of pressurizing the composition sheet for heat-diffusion sheet (30, 53) is 50 to 200 kgf/cm², and the pre-heating temperature is 50 to 80°C; and
in the curing step, the pressure at the time of pressurizing the composition sheet for heat-diffusion sheet is 50 to 200 kgf/cm², and the temperature of the curing starting temperature or higher is 130 to 200°C.

10. The method of producing a heat-diffusion sheet (30, 53) according to claim 9, wherein
in the pre-heating step, the heating time of pre-heating the composition sheet for heat-diffusion sheet (30, 53) at the pre-heating temperature is 5 to 10 minutes; and
in the curing step, the heating time of heating the composition sheet for heat-diffusion sheet (30, 53) at a temperature of the curing starting temperature or higher is 10 to 60 minutes.

11. The method of producing a heat-diffusion sheet (30, 53) according to claim 9 or 10, further comprising a low-molecular weight siloxane removal step of heating the composition sheet for heat-diffusion sheet (30, 53) heated at a temperature of the curing starting temperature or higher at a heating temperature of 130 to 200°C for 2 to 30 hours.

## Patentansprüche

1. Wärmeabstrahlende Folie (30, 53) mit einer Dicke von mehr als 10 µm,
wobei ein Abstand zwischen einem distalen Ende einer Nadelelektrode (23) und einer Aluminiumplatte (22, 25) zum Zeitpunkt eines Spannungsdurchschlags der wärmeabstrahlenden Folie (30, 53) größer als 0 µm und 80 µm oder kleiner ist oder die Nadelelektrode (23) die Aluminiumplatte (22, 25) ohne Spannungsdurchschlag der wärmeabstrahlenden Folie (30, 53) kurzschließt, wenn ein Spannungsdurchschlagtest durchgeführt wird und der Durchschlagtest umfasst, dass eine Nadelelektrode (23), die einen Konus mit einer Höhe von 3 mm und einen Bodenflächendurchmesser von 0,75 mm an einem distalen Endabschnitt davon aufweist und an die eine Wechselspannung von 2,0 kV mit einer Frequenz von 60 Hz angelegt wurde, nicht nur schrittweise alle 10 µm in die wärmeabstrahlende Folie (30, 53), die unmittelbar auf einer Aluminiumplatte (22, 25) angeordnet ist, in der Dickenrichtung der wärmeabstrahlenden Folie (30, 53) von der Oberfläche auf der Seite, die der mit der Aluminiumplatte (22, 25) in Kontakt stehenden Oberfläche der wärmeabstrahlenden Folie (30, 53) gegenüberliegt, eingestochen wird, sondern auch vor dem Einstechen und bei jedem der Schritte 60 Sekunden gehalten wird.

2. Wärmeabstrahlende Folie (30, 53) nach Anspruch 1, wobei der Abstand zwischen dem distalen Ende der Nadelelektrode (23) und der Aluminiumplatte (22, 25) zum Zeitpunkt des Spannungsdurchschlags der wärmeabstrahlenden Folie (30, 53) 50 µm oder kleiner ist, wenn der Spannungsdurchschlagtest durchgeführt wird.

3. Wärmeabstrahlende Folie (30, 53) nach Anspruch 1 oder 2, die ein Harz-Bindemittel und einen anorganischen Füllstoff umfasst.

4. Wärmeabstrahlende Folie (30, 53) nach Anspruch 3, wobei das Harz-Bindemittel ein Siliconharz ist.

5. Wärmeabstrahlende Folie (30, 53) nach Anspruch 3 oder 4, wobei der anorganische Füllstoff ein koaguliertes Partikel aus hexagonalem Bornitrid ist.

6. Wärmeabstrahlende Folie (30, 53) nach einem der Ansprüche 3 bis 5, die ein Glasfasergewebe umfasst.

7. Wärmeabstrahlende Folie (30, 53) nach einem der Ansprüche 3 bis 6, die eine Basismaterial-Harzschicht umfasst, die ein Harz mit einem Glasübergangspunkt von 200 °C oder höher enthält.

8. Verfahren zur Herstellung einer wärmeabstrahlenden Folie (30, 53), umfassend:
einen Zusammensetzungsherstellungsschritt des Mischens einer flüssigen Harzzusammensetzung, eines anorganischen Füllstoffs und eines Lösungsmittels, um eine Zusammensetzung für eine wärmeabstrahlende Folie (30, 53) herzustellen;
einen Folienformungsschritt des Formens der Zusammensetzung für eine wärmeabstrahlende Folie (30, 53) in eine Folienform, um eine Zusammensetzungsfolie für eine wärmeabstrahlende Folie (30, 53) herzustellen;
einen Vorwärmschritt des Vorwärmens der Zusammensetzungsfolie für eine wärmeabstrahlende Folie (30, 53) bei einer Vorwärmtemperatur, die niedriger als eine Aushärtungs-Starttemperatur ist, während die Zusammensetzungsfolie für eine wärmeabstrahlende Folie (30, 53) mit Druck beaufschlagt wird, und
einen Aushärtungsschritt des Erwärmens der Zusammensetzungsfolie für eine wärmeabstrahlende Folie (30, 53) bei einer Temperatur, welche die Aushärtungs-Starttemperatur oder höher ist, während die vorgewärmte Zusammensetzungsfolie für eine wärmeabstrahlende Folie (30, 53) mit Druck beaufschlagt wird,
wobei der anorganische Füllstoff ein massiv koaguliertes Partikel ist und die Zusammensetzungsfolie für eine wärmeabstrahlende Folie (30, 53) in dem Vorwärmschritt nicht ausgehärtet wird.

9. Verfahren zur Herstellung einer wärmeabstrahlenden Folie (30, 53) nach Anspruch 8, wobei
die flüssige Harzzusammensetzung eine flüssige Siliconharzzusammensetzung ist,
der anorganische Füllstoff ein koaguliertes Partikel aus hexagonalem Bornitrid ist,
in dem Vorwärmschritt der Druck zum Zeitpunkt des Beaufschlagens der Zusammensetzungsfolie für eine wärmeabstrahlende Folie (30, 53) mit Druck 50 bis 200 kgf/cm² beträgt und die Vorwärmtemperatur 50 bis 80 °C beträgt; und
in dem Aushärtungsschritt der Druck zum Zeitpunkt des Beaufschlagens der Zusammensetzungsfolie für eine wärmeabstrahlende Folie mit Druck 50 bis 200 kgf/cm² beträgt und die Temperatur, welche die Aushärtungs-Starttemperatur oder höher ist, 130 bis 200 °C beträgt.

10. Verfahren zur Herstellung einer wärmeabstrahlenden Folie (30, 53) nach Anspruch 9, wobei
in dem Vorwärmschritt die Erwärmungszeit des Vorwärmens der Zusammensetzungsfolie für eine wärmeabstrahlende Folie (30, 53) bei der Vorwärmtemperatur 5 bis 10 Minuten beträgt; und
in dem Aushärtungsschritt die Erwärmungszeit des Erwärmens der Zusammensetzungsfolie für eine wärmeabstrahlende Folie (30, 53) bei einer Temperatur, welche die Aushärtungs-Starttemperatur oder höher ist, 10 bis 60 Minuten beträgt.

11. Verfahren zur Herstellung einer wärmeabstrahlenden Folie (30, 53) nach Anspruch 9 oder 10, ferner umfassend einen Schritt der Entfernung von Siloxan mit niedrigem Molekulargewicht des Erwärmens der Zusammensetzungsfolie für eine wärmeabstrahlende Folie (30, 53), die bei einer Temperatur, welche die Aushärtungs-Starttemperatur oder höher ist, erwärmt wurde, bei einer Erwärmungstemperatur von 130 bis 200 °C für 2 bis 30 Stunden.

## Revendications

1. Feuille de diffusion thermique (30, 53) ayant une épaisseur de plus de 10 µm,
dans laquelle une distance entre une extrémité distale d'une électrode aiguille (23) et une plaque d'aluminium (22, 25) au moment de la rupture diélectrique de la feuille de diffusion thermique (30, 53) est supérieure à 0 µm et de 80 µm ou moins, ou l'électrode aiguille (23) court-circuite la plaque d'aluminium (22, 25) sans rupture diélectrique de la feuille de diffusion thermique (30, 53), lorsqu'un essai de rupture diélectrique est effectué et que l'essai de rupture comprend une électrode aiguille (23) ayant un cône ayant une hauteur de 3 mm et d'un diamètre de surface de fond de 0,75 mm au niveau d'une section d'extrémité distale de celle-ci, à laquelle a été appliquée une tension de courant alternatif de 2,0 kV ayant une fréquence de 60 Hz, n'est pas seulement pénétrée par étapes tous les 10 µm dans la feuille de diffusion thermique (30, 53) placée directement sur une plaque d'aluminium (22, 25) dans la direction de l'épaisseur de la feuille de diffusion thermique (30, 53) depuis la surface du côté opposé à la surface en contact avec la plaque d'aluminium (22, 25) de la feuille de diffusion thermique (30, 53), mais aussi retenue pendant 60 secondes avant la pénétration et à chacune des étapes.

2. Feuille de diffusion thermique (30, 53) selon la revendication 1, dans laquelle la distance entre l'extrémité distale de l'électrode aiguille (23) et la plaque d'aluminium (22, 25) au moment de la rupture diélectrique de la feuille de diffusion thermique (30, 53) est de 50 µm ou moins, lorsque l'essai de rupture diélectrique est effectué.

3. Feuille de diffusion thermique (30, 53) selon la revendication 1 ou 2, comprenant un liant résineux et une charge inorganique.

4. Feuille de diffusion thermique (30, 53) selon la revendication 3, dans laquelle le liant résineux est une résine de silicone.

5. Feuille de diffusion thermique (30, 53) selon la revendication 3 ou 4, dans laquelle la charge inorganique est une particule coagulée de nitrure de bore hexagonal.

6. Feuille de diffusion thermique (30, 53) selon l'une quelconque des revendications 3 à 5, comprenant un tissu de verre.

7. Feuille de diffusion thermique (30, 53) selon l'une quelconque des revendications 3 à 6, comprenant une couche de résine de matériau de base incluant une résine ayant un point de transition vitreuse de 200 °C ou plus.

8. Procédé de production d'une feuille de diffusion thermique (30, 53), comprenant
une étape de fabrication de composition consistant à mélanger une composition de résine liquide, une charge inorganique et un solvant pour fabriquer une composition pour feuille de diffusion thermique (30, 53) ;
une étape de moulage de feuille consistant à mouler la composition pour feuille de diffusion thermique (30, 53) sous une forme de feuille pour fabriquer une feuille de composition pour feuille de diffusion thermique (30, 53) ;
une étape de préchauffage consistant à préchauffer la feuille de composition pour feuille de diffusion thermique (30, 53) à une température de préchauffage inférieure à une température de début de durcissement tout en pressurisant la feuille de composition pour feuille de diffusion thermique (30, 53) ; et
une étape de durcissement consistant à chauffer la feuille de composition pour feuille de diffusion thermique (30, 53) à une température égale ou supérieure à la température de début de durcissement tout en pressurisant la feuille de composition préchauffée pour feuille de diffusion thermique (30, 53),
dans lequel la charge inorganique est une particule massivement coagulée, et la feuille de composition pour feuille de diffusion thermique (30, 53) n'est pas durcie dans l'étape de préchauffage.

9. Procédé de production d'une feuille de diffusion thermique (30, 53) selon la revendication 8, dans lequel
la composition de résine liquide est une composition de résine de silicone liquide ;
la charge inorganique est une particule coagulée de nitrure de bore hexagonal ;
dans l'étape de préchauffage, la pression au moment de la pressurisation de la feuille de composition pour feuille de diffusion de chaleur (30, 53) est de 50 à 200 kgf/cm², et la température de préchauffage est de 50 à 80°C ; et
dans l'étape de durcissement, la pression au moment de la pressurisation de la feuille de composition pour feuille de diffusion thermique est de 50 à 200 kgf/cm², et la température égale ou supérieure à la température de début de durcissement est de 130 à 200 °C.

10. Procédé de production d'une feuille de diffusion thermique (30, 53) selon la revendication 9, dans lequel
dans l'étape de préchauffage, la durée de chauffage du préchauffage de la feuille de composition pour feuille de diffusion thermique (30, 53) à la température de préchauffage est de 5 à 10 minutes ; et
dans l'étape de durcissement, la durée de chauffage du chauffage de la feuille de composition pour feuille de diffusion thermique (30, 53) à une température égale ou supérieure à la température de début de durcissement est de 10 à 60 minutes.

11. Procédé de production d'une feuille de diffusion thermique (30, 53) selon la revendication 9 ou 10, comprenant en outre une étape d'élimination de siloxane de faible poids moléculaire consistant à chauffer la feuille de composition pour feuille de diffusion thermique (30, 53) chauffée à une température égale ou supérieure à la température de début de durcissement à une température de chauffage de 130 à 200 °C pendant 2 à 30 heures.
